# EUROPÄISCHE PATENTANMELDUNG

(11) **EP 4 718 102 A1**
(43) Veröffentlichungstag der Anmeldung: **01.04.2026**
(21) Anmeldenummer: 24203080.7
(22) Anmeldetag: 27.09.2024
(51) Int. Cl.: G01R 33/561, G01R 33/565

(54) **AUFNAHME VON REFERENZDATEN ZUR KORREKTUR VON MITTELS EINER ECHOPLANAR-SEQUENZ AUFGENOMMENEN MAGNETRESONANZMESSDATEN**

(71) Anmelder: Siemens Healthineers AG, 91301 Forchheim (DE)
(72) Erfinder: Kettinger, Adam, 91056 Erlangen (DE); Rösler, Manuela, 91054 Erlangen (DE)
(74) Vertreter: Siemens Healthineers Patent Attorneys

(57) **Zusammenfassung**

Ein erfindungsgemäßes Verfahren zur Aufnahme von Referenzdaten zur Korrektur von mittels einer Echoplanar-Sequenz mittels einer Magnetresonanzanlage (1) aus einem Untersuchungsobjekt (U) aufgenommenen Messdaten (MD) umfasst die Schritte:
- Einstrahlen eines RF-Anregungspulses (RF1) zum Anregen von Spins in dem Untersuchungsobjekt (U),
- Erfassen von Messdaten durch Aufnehmen von Echosignalen durch den RF-Anregungspuls angeregter Spins in einem Auslesezeitraum (MW) durch Schalten von in ihrer Polarität alternierenden Auslesegradienten, die einen bipolaren Auslesegradientenzug (GT) bilden,
- Fortführen des Schaltens von in ihrer Polarität alternierenden Auslesegradienten nach dem Erfassen der Messdaten (MD) in dem Auslesezeitraum (MW), sodass der Auslesegradientenzug (GT) um mindestens drei, den Auslesegradientenzug (GT) fortsetzende, in ihrer Polarität alternierende weitere Auslesegradienten verlängert ist,
- Erfassen von Referenzdaten (RD) durch Aufnehmen von mindestens drei weiteren Echosignalen während jeweils eines weiteren Auslesegradienten,
- Auf Basis der erfassten Referenzdaten, Bestimmen von Korrekturdaten (KD) zur Phasenkorrektur von in den Messdaten (MD) enthaltenen Phasenfehlern.

## Beschreibung

Die Erfindung betrifft eine verbesserte Aufnahme von Referenzdaten zur Korrektur von mittels einer Echoplanar-Sequenz aufgenommenen Magnetresonanzmessdaten.

Die Magnetresonanz-Technik (im Folgenden steht die Abkürzung MR für Magnetresonanz) ist eine bekannte Technik, mit der Bilder vom Inneren eines Untersuchungsobjektes erzeugt werden können. Vereinfacht ausgedrückt wird hierzu das Untersuchungsobjekt in einer Magnetresonanzanlage in einem durch eine Magneteinheit erzeugten, vergleichsweise starken statischen, homogenen Grundmagnetfeld, auch B0-Feld genannt, mit Feldstärken von 0,05 Tesla über 0,2 Tesla bis 7 Tesla und mehr positioniert, so dass sich dessen Kernspins entlang des Grundmagnetfeldes orientieren. Zum Auslösen von als Signale messbaren Kernspinresonanzen werden hochfrequente Anregungspulse (RF-Pulse) in das Untersuchungsobjekt eingestrahlt, die ausgelösten Kernspinresonanzen als sogenannte k-Raumdaten mittels zum Empfang ausgelegten Spulen gemessen und auf deren Basis MR-Bilder rekonstruiert oder Spektroskopiedaten ermittelt. Das durch die mittels mindestens einer Sendespule eingestrahlten Anregungspulse erzeugte magnetische Wechselfeld wird auch als B1-Feld oder B1+-Feld bezeichnet. Eine Magnetresonanzanlage verfügt in aller Regel zumindest über eine fest eingebaute sogenannte Körperspule, mit welcher RF-Pulse eingestrahlt und ggf. auch ausgelöste Signale empfangen werden können. Zur Ortskodierung der Messdaten werden dem Grundmagnetfeld mittels einer Gradienteneinheit schnell geschaltete magnetische Gradientenfelder, kurz Gradienten genannt, überlagert. Ein verwendetes Schema, das eine zeitliche Abfolge von einzustrahlenden RF-Pulsen und zu schaltenden Gradienten beschreibt, wird als Pulssequenz(schema), oder auch kurz als Sequenz, bezeichnet. Die aufgezeichneten Messdaten werden digitalisiert und als komplexe Zahlenwerte in einer k-Raum-Matrix abgelegt. Aus der mit Werten belegten k-Raum-Matrix ist z.B. mittels einer mehrdimensionalen Fourier-Transformation ein zugehöriges MR-Bild rekonstruierbar. Die Komponenten einer Magnetresonanzanlage, welche das erzeugte Magnetfeld beeinflussen, wie die Magneteinheit, die Gradienteneinheit, die Körperspule, ggf platzierte Lokalspulen und ggf. vorhandene sogenannte Shim-Spulen zur Verbesserung der Homogenität des Grundmagnetfelds, können zusammen als Magnetfelderzeugungseinheit einer Magnetresonanzanlage bezeichnet werden.

Eine der schnellsten bekannten MR-Aufnahmetechniken ist das sogenannte Echoplanar-Imaging (EPI), bei welchem nach einem RF-Anregungspuls in einem Auslesezeitraum ein oszillierender, also bipolarer Auslesegradient eingesetzt wird, der bei jeder Änderung der Polarisationsrichtung des Gradienten die transversale Magnetisierung so weit refokussiert, wie es der T2*-Zerfall erlaubt, und damit je ein Gradientenecho erzeugt. Zusätzlich wird während jeder Änderung der Polarisationsrichtung des Auslesegradienten ein kurzer Gradient in Phasenkodierrichtung, auch Phasen-Blip-Gradient genannt, geschaltet, sodass nach einer Änderung der Polarisationsrichtung des Auslesegradienten eine andere, durch den Phasen-Blip-Gradienten kodierte, k-Raumzeile aufgenommen wird. Mit anderen Worten wird durch die Schaltung des bipolaren Auslesegradienten nach einem RF-Anregungspuls innerhalb des freien Induktionsabfalls nach der Anregung (FID, engl. "free induction decay"), oder wenn zusätzlich ein RF-Refokussierungspuls nach dem RF-Anregungspuls eingestrahlt wird, innerhalb des so erzeugten Spinechos, ein Echozug von Gradientenechos mit wechselnden Vorzeichen erzeugt. EPI-Pulssequenzen können als sogenannte "Single-Shot"-Verfahren eingesetzt werden, bei welchen alle Messdaten zur Erzeugung eines Bildes eines Subvolumens, z.B. einer Schicht, des untersuchten Untersuchungsobjektes nach nur einem RF-Anregungspuls aufgenommen werden.

Durch das schnelle An- und Abschalten der Auslesegradienten auf hohe Gradientenstärken werden Wechselwirkungen zwischen Magneteinheit und Gradienteneinheit erzeugt, bei denen Schwingungen verursacht werden, welche die gesamte Messung beeinträchtigen können. Denn es werden aufgrund der schnellen Änderung der Gradienten gradienteninduzierte Wirbelströme erzeugt, welche auf elektrisch leitfähigen Strukturen und insbesondere auch auf resonant angeregten, elektrisch leitfähigen Strukturen der Magnetfelderzeugungseinheit entstehen, und dem Aufbau des geplanten Gradientenfelds entgegenwirken. Man unterscheidet zwischen primären Wirbelströmen, welche infolge der Magnetfeldgradienten erzeugt werden, und sekundären Wirbelströmen. Aufgrund der induzierten primären Wirbelströme im Grundmagnetfeld entstehen Lorenzkräfte. Wenn die Lorenzkräfte mechanische Resonanzen anregen, so werden aufgrund dieser mechanischen Schwingungen sekundäre Wirbelströme erzeugt. Diese Reduktion des Gradientenfelds bewirkt, dass das Signalmaximum nicht in der Mitte des k-Raums registriert wird, sondern bei ungeraden Phasenkodierschritten hinter der Mitte des k-Raums und bei geraden Phasenkodierschritten vor der Mitte des k-Raums registriert wird.

Wegen der wechselnden Polarität des Auslesegradienten müssen die aus den Gradientenechosignalen gewonnenen Messdaten in eine Rohdaten-k-Raummatrix derart einsortiert werden, dass die Einsortierrichtung von Zeile zu Zeile der Rohdaten-k-Raummatrix wechselt. Wenn sich hierbei von Zeile zu Zeile, z.B. durch Verzögerungen in der Gradientenschaltung wegen oben genannter Wirbelströme, auch nur geringfügige Abweichungen ergeben, führt dies zu sogenannten N/2-Geistern, d. h. bei einer Bildmatrix von NxN-Punkten wird das eigentliche Bild um N/2 verschoben in positiver und negativer Richtung bezüglich der Bildmatrixmitte nochmals abgebildet, und zwar im Allgemeinen mit verschiedener Intensität.

Ähnliche Phänomene treten auch vibrationsinduziert bei einer Anregung in der mechanischen Resonanz der Gradientenspule auf. Die Wirbelströme können also nicht nur direkt durch schnelle Magnetfeldänderungen generiert werden, sondern auch durch bewegte, elektrisch leitfähige Komponenten, die von Magnetfeldern durchsetzt sind. Bisher angewendete Kompensationsverfahren sind nicht besonders effektiv oder haben andere negative Auswirkungen auf angewendete Bildgebungssequenzen. Beispielsweise verlängern sie die Gesamtakquisitionszeit und die minimal mögliche Echozeit sowie die Anfälligkeit hinsichtlich des Magnetfelddrifts. Eine Magnetfelddrift kann durch Erwärmung einzelner Komponenten, insbesondere der Gradientenspule oder der sogenannten Shimeisen, hervorgerufen werden.

Als Gegenmaßnahmen wurden bisher gewisse Echozeiten im Zusammenhang mit EPI-Sequenzen verboten, insbesondere Echozeiten, die Eigenresonanzen von Gradientenspulen entsprechen. Allerdings führt eine solche Vorgehensweise aufgrund der starken Dämpfung der Schwingung im Magnetfeld dazu, dass ein sehr breiter Bereich von Echozeiten verboten werden muss. Dadurch wird eine Optimierung von Bildgebungssequenzen stark eingeschränkt.

Als weitere Gegenmaßnahme wurden Referenzaufnahmen zur Phasenkorrektur im eingeschwungenen und/oder identischen mechanischen Zustand der Gradienteneinheit vorgenommen. Zur Korrektur derartiger N/2-Geister ist es beispielsweise aus der US6043651 bekannt, drei Navigatorsignale unter Schalten eines bipolaren Auslesegradienten aufzunehmen, mit welchen eine Korrektur von Phasenverschiebungen nullter und erster Ordnung zwischen mit unterschiedlicher Polarität aufgenommenen Gradientenechos in Ausleserichtung durchgeführt werden kann, welche derartige Verschiebungen korrigieren kann. Dazu wird eine Korrelation der aufgenommenen Navigatorsignale im Bildraum genutzt, um Korrekturfaktoren zu bestimmen, welche bei einer Rekonstruktion von Bilddaten aus den als Messdaten in einer Rohdaten-k-Raummatrix aufgenommenen Gradientenechos genutzt werden, um die genannten Verschiebungen in der Rohdaten-k-Raummatrix zu korrigieren.

Es sind bereits verschiedene Techniken zur Aufnahme derartiger dreier Navigatorsignale als Referenzdaten bekannt.

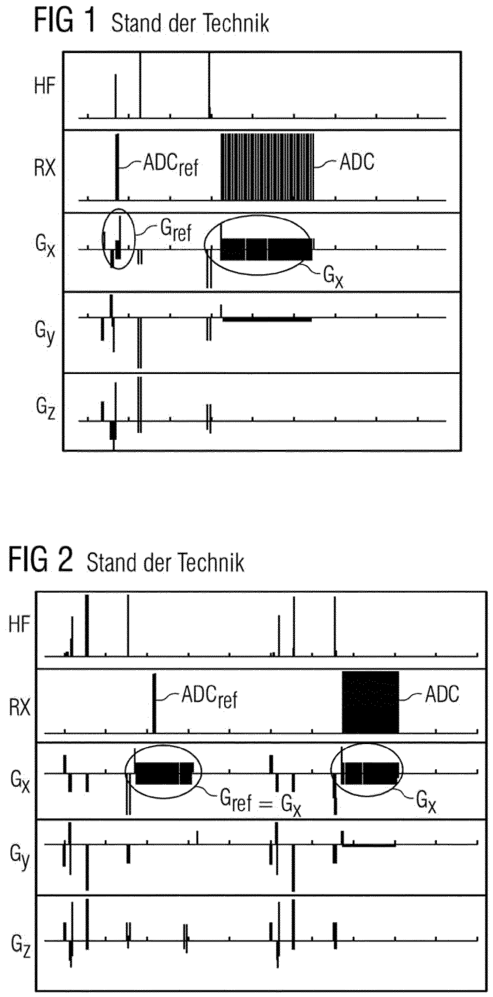

Bei einem auch als "interne Phasenkorrektur" oder "3-Linien-B₀"-Korrektur bezeichneten Verfahren werden drei Referenzlinien vor jedem Auslesezeitraum erfasst. Eine interne Phasenkorrektur ist in FIG 1 anhand eines beispielhaften Pulssequenzdiagramms veranschaulicht. Die Zeit für das Auslesen der Referenzlinien ist relativ kurz, muss aber zusätzlich zu der Zeit für die eigentliche EPI-Sequenz aufgebracht werden. Die Auslesesequenz für das Auslesen der drei Referenzlinien unterscheidet sich von dem Auslesezug der eigentlichen EPI-Sequenz zur Bildakquisition. Der zusätzliche Zeitbedarf ist mit etwa 5 ms (ms = Millisekunden) für jeden EPI-Auslesezug vergleichsweise gering. Insgesamt zeichnet sich die interne Phasenkorrektur durch kurze Messzeiten und durch eine (der Möglichkeit einer Aufnahme der drei Referenzlinien vor jedem Auslesezeitraum der bildgebenden EPI-Sequenz geschuldete) hohe Robustheit gegenüber Patientenbewegungen aus.

Bei einem auch als "externe Phasenkorrektur" bezeichneten Verfahren, welche in FIG 2 veranschaulicht ist, erfolgt bei dem Auslesen der drei Referenzlinien ein Ausspielen eines gesamten Auslesegradienten, wie er später auch für die Bildakquisition der EPI-Sequenz eingesetzt wird. Bei dieser Herangehensweise ist die Artefaktunterdrückung besonders stark, da jeweilige relevante zeitliche Zusammenhänge, wie z.B. effektive Echozeiten für die Aufnahme der Navigatorsignale und der für die Bildgebung aufgenommenen Signale gleich sind. Allerdings ist der Zeitaufwand aufgrund des Ausspielens des gesamten Auslesegradienten bei dem Ausspielen und Auslesen der Referenzlinien besonders groß, weshalb in aller Regel die drei Referenzlinien nur einmal, beispielsweise zu Beginn der gesamten Messung, aufgenommen und für eine Korrektur aller für die Bildakquisition mit der EPI-Sequenz aufgenommener Messdaten verwendet werden. Der zusätzliche Zeitbedarf liegt ungefähr bei der Repetitionszeit der EPI-Sequenz. Kommt es zu Feldabweichungen zwischen unterschiedlichen Repetitionen, so kann die Korrektur ungenau werden. Die externe Phasenkorrektur ist auch sensibel auf Patientenbewegungen. Ansonsten wird die Bildqualität durch die externe Phasenkorrektur im Vergleich zur internen Phasenkorrektur erhöht.

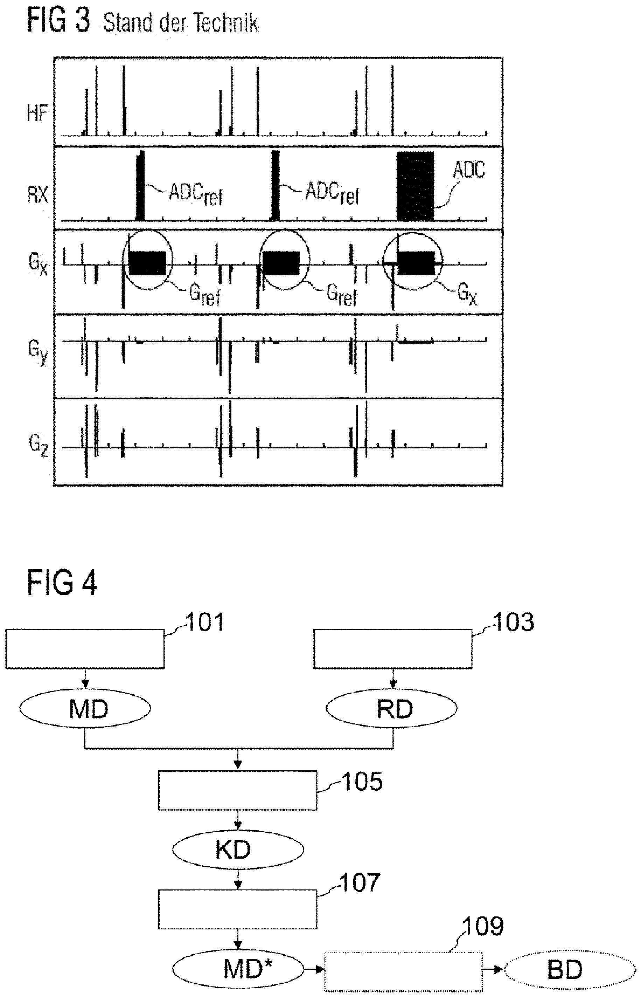

Bei einer dritten bekannten Methode, welche in FIG 3 veranschaulicht ist, erfolgt die Reduktion von Geisterartefakten auf Basis einer GRAPPA-Referenzaufnahme. Hierzu erfolgen zwei zusätzliche Referenzaufnahmen zu Beginn einer EPI-Sequenz, um GRAPPA-ähnliche Kernel aufzunehmen, mit denen Imperfektionen der bei der Rohdatenakquisition abgetasteten k-Raum-Trajektorie korrigiert werden sollen. Auch hier wird der vollständige Auslesegradient während der Referenzaufnahme ausgespielt. Der zusätzliche Zeitbedarf liegt hier bei dem Zweifachen der Repetitionszeit der eigentlichen EPI-Sequenz. Kommt es zu Feldabweichungen zwischen unterschiedlichen Repetitionen, so kann die Korrektur ungenau werden. Ein Beispiel einer solchen Vorgehensweise ist in dem Artikel von Hoge et al, "Dual-Polarity GRAPPA for Simultaneous Reconstruction and Ghost Correction of Echo Planar Imaging Data", Magn. Reson. Med. 76: S. 32-44, 2016, genauer beschrieben.

Ein weiteres, DORK genanntes, Phasenkorrekturverfahren zur Korrektur von durch zeitliche Variationen eines während einer EPI-Messung anliegenden Grundmagnetfeldes, z.B. einen Drift, verursachte Verschiebungen, bei welchem ein Navigatorsignal aufgenommen wird, ist z.B. aus der US9329254B2 bekannt. Dabei wird eine Evolution der Gradientenechos, welche mit einer Polarität aufgenommen wurden, mit einer Evolution der Gradientenechos, welche mit der anderen Polarität aufgenommen wurden, über aufeinanderfolgende Aufnahmen von Rohdaten-k-Raummatrizen verglichen. Üblicherweise wird bei einer solchen DORK-Korrektur über ein gesamtes Bildvolumen gemittelt. DORK-Verfahren sind üblicherweise auch auf Basis dreier zur Korrektur von N/2-Geistern aufgenommenen Navigatorsignale durchführbar und werden häufig in Verbindung mit interner und externer Phasenkorrektur eingesetzt.

Beispielsweise in der US10162037B2, der US12025686B2 und der US20240036142A1 sind weitere Phasenkorrekturverfahren für mittels einer Echoplanar-Sequenz und mit einem Schicht-multiplexing(SMS)-Verfahren (SMS, engl. "simultaneous multi-slice") aufgenommene Messdaten beschrieben, die mehr als drei Referenzsignale als Referenzdaten erfassen.

Es besteht Bedarf ein Verfahren zur Durchführung einer Magnetresonanzbildgebung mit einer Echoplanar-Sequenz mit hoher Bildqualität und erhöhter Robustheit gegenüber Bewegungen sowie mit verringertem Zeitaufwand im Vergleich zu bisherigen Vorgehensweisen zu entwickeln.

Der Erfindung liegt die Aufgabe zugrunde, eine Korrektur von mittels einer EPI-Sequenz aufgenommenen Messdaten zu verbessern, insbesondere eine Aufnahme von Referenzdaten für eine solche Korrektur anzugeben, mit welcher eine hohe Bildqualität bei erhöhter Robustheit gegenüber Bewegungen sowie mit verringertem Zeitaufwand im Vergleich zu bisherigen Vorgehensweisen erreicht wird.

Die Aufgabe wird gelöst durch ein Verfahren zur Aufnahme von Referenzdaten zur Korrektur von mittels einer Echoplanar-Sequenz mittels einer Magnetresonanzanlage aus einem Untersuchungsobjekt aufgenommenen Messdaten gemäß Anspruch 1, eine Magnetresonanzanlage gemäß Anspruch 8, ein Computerprogramm gemäß Anspruch 9, sowie einen elektronisch lesbaren Datenträger gemäß Anspruch 10.

Ein erfindungsgemäßes Verfahren zur Aufnahme von Referenzdaten zur Korrektur von mittels einer Echoplanar-Sequenz mittels einer Magnetresonanzanlage aus einem Untersuchungsobjekt aufgenommenen Messdaten umfasst die Schritte:
- Einstrahlen eines RF-Anregungspulses zum Anregen von Spins in dem Untersuchungsobjekt,
- Erfassen von Messdaten durch Aufnehmen von Echosignalen durch den RF-Anregungspuls angeregter Spins in einem Auslesezeitraum durch Schalten von in ihrer Polarität alternierenden Auslesegradienten, die einen bipolaren Auslesegradientenzug bilden,
- Fortführen des Schaltens von in ihrer Polarität alternierenden Auslesegradienten nach dem Erfassen der Messdaten in dem Auslesezeitraum, sodass der Auslesegradientenzug um einen Referenzauslesezeitraum, welcher mindestens drei in ihrer Polarität alternierende weitere Auslesegradienten umfasst, verlängert ist,
- Erfassen von Referenzdaten durch Aufnehmen von mindestens drei weiteren Echosignalen während jeweils eines weiteren Auslesegradienten,
- Auf Basis der erfassten Referenzdaten, Bestimmen von Korrekturdaten zur Phasenkorrektur von in den Messdaten enthaltenen Phasenfehlern.

Durch das erfindungsgemäße Verlängern des Auslesegradientenzugs um mindestens drei weitere Auslesegradienten und das Aufnehmen von Echosignalen als Referenzdaten RD in einem Referenzauslesezeitraum, in dem diese weiteren Auslesegradienten geschaltet werden, bleibt ein mechanischer, im Laufe des Auslesezeitraums eingeschwungener Stabilitätszustand (engl. "steady-state") auch während der Aufnahme der als Referenzdaten erfassten Echosignale erhalten, wodurch die Referenzdaten bei gleichen Bedingungen erfasst wurden wie die zu korrigierenden Messdaten, was eine Korrektur von Phasenfehlern verbessert. Damit können Geister-Artefakte effektiver reduziert werden. Darüber hinaus sind durch die zeitlich eng aufeinanderfolgende Aufnahme von als Messdaten erfassten Echosignalen einerseits und als Referenzdaten erfassten Echosignalen andererseits die so gewonnenen Referenzdaten geeignet, um eine dynamische Phasenkorrektur zu erlauben, da stets neue, unter gleichen Bedingungen wie die letzten Messdaten erfasste Referenzdaten erfasst werden. Eine Korrektur von durch Temperaturschwankungen und/oder einen Drift des Magnetfeldes verursachten Phasenfehlern, z.B. mittels eines DORK-Verfahrens, kann somit entfallen. Dadurch, dass die Referenzdaten nach den zu korrigierenden Messdaten erfasst werden, wird weiterhin eine minimal mögliche Echozeit TE bei der Aufnahme der als Messdaten erfassten Echosignale nicht durch die Aufnahme der als Referenzdaten erfassten Echosignale beeinflusst, sodass durch das Erfassen der Referenzdaten keine Einschränkungen, z.B. bei der Kontrastwahl, der Aufnahme der als Messdaten erfassten Echosignale entstehen. Weil, ähnlich wie bei einer internen Phasenkorrektur, Referenzdaten in jedem Auslesezeitraum erfasst werden, hat auch das erfindungsgemäße Verfahren eine hohe Robustheit gegenüber Bewegungen des Untersuchungsobjektes, beispielsweise eines Patienten.

Eine erfindungsgemäße Magnetresonanzanlage umfasst eine Magneteinheit, eine Gradienteneinheit, eine Hochfrequenzeinheit und eine zur Durchführung eines erfindungsgemäßen Verfahrens ausgebildete Steuereinrichtung mit einer Referenzdateneinheit.

Ein erfindungsgemäßes Computerprogramm implementiert ein erfindungsgemäßes Verfahren auf einer Steuereinrichtung, wenn es auf der Steuereinrichtung ausgeführt wird. Beispielsweise umfasst das Computerprogramm Befehle, die bei der Ausführung des Programms durch eine Steuereinrichtung, z.B. eine Steuereinrichtung einer Magnetresonanzanlage, diese Steuereinrichtung veranlassen, ein erfindungsgemäßes Verfahren auszuführen. Die Steuereinrichtung kann in Form eines Computers gestaltet sein.

Das Computerprogramm kann hierbei auch in Form eines Computerprogrammprodukts vorliegen, welches direkt in einen Speicher einer Steuereinrichtung ladbar ist, mit Programmcode-Mitteln, um ein erfindungsgemäßes Verfahren auszuführen, wenn das Computerprogrammprodukt in einer Recheneinheit des Rechensystems ausgeführt wird.

Ein erfindungsgemäßes computerlesbares Speichermedium umfasst Befehle, die bei der Ausführung durch eine Steuereinrichtung, z.B. eine Steuereinrichtung einer Magnetresonanzanlage, diese veranlassen, ein erfindungsgemäßes Verfahren auszuführen.

Das computerlesbare Speichermedium kann als elektronisch lesbarer Datenträger ausgestaltet sein, welcher darauf gespeicherte elektronisch lesbare Steuerinformationen umfasst, welche zumindest ein erfindungsgemäßes Computerprogramm umfassen und derart ausgestaltet sind, dass sie bei Verwendung des Datenträgers in einer Steuereinrichtung einer Magnetresonanzanlage ein erfindungsgemäßes Verfahren durchführen.

Die in Bezug auf das Verfahren angegebenen Vorteile und Ausführungen gelten analog auch für die Magnetresonanzanlage, das Computerprogrammprodukt und den elektronisch lesbaren Datenträger.

Weitere Vorteile und Einzelheiten der vorliegenden Erfindung ergeben sich aus den im Folgenden beschriebenen Ausführungsbeispielen sowie anhand der Zeichnungen. Die aufgeführten Beispiele stellen keine Beschränkung der Erfindung dar. Es zeigen:
Fig. 1 eine schematische Darstellung eines Pulssequenzdiagramms für eine interne Phasenkorrektur,
Fig. 2 eine schematische Darstellung eines Pulssequenzdiagramms für eine externe Phasenkorrektur,
Fig. 3 eine schematische Darstellung eines Pulssequenzdiagramms für eine Phasenkorrektur, welche auf Basis einer GRAPPA-Referenzaufnahme erfolgt,
Fig. 4 ein schematisches Ablaufdiagramm eines erfindungsgemäßen Verfahrens zur Bestimmung von Spulensensitivitätsdaten,
Fig. 5 eine schematische Darstellung eines Pulssequenzdiagramms für beispielhafte erfindungsgemäße Aufnahmen von Referenzdaten für eine Phasenkorrektur,
Fig. 6 eine schematisch dargestellte erfindungsgemäße Magnetresonanzanlage.
Figur 4 ist ein schematisches Ablaufdiagramm eines erfindungsgemäßen Verfahrens zur Aufnahme von Referenzdaten RD zur Korrektur von mittels einer Echoplanar-Sequenz mittels einer Magnetresonanzanlage 1 aus einem Untersuchungsobjekt U aufgenommenen Messdaten MD.

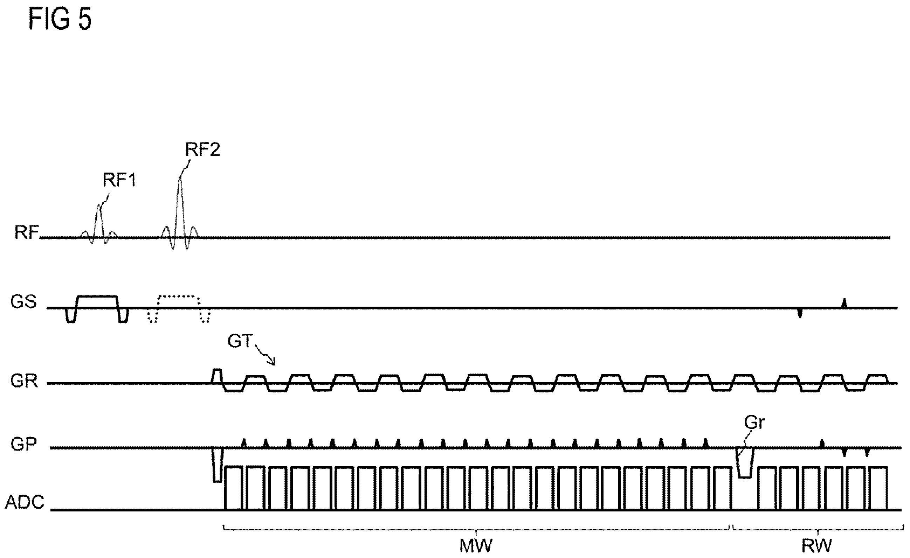

Figur 5 ist eine schematische Darstellung eines Pulssequenzdiagramms für beispielhafte erfindungsgemäße Aufnahmen von Referenzdaten RD für eine Phasenkorrektur. In Figur 5 sind eingestrahlte RF-Pulse, zu schaltende Gradienten und eine Datenaufnahme in ihrem zeitlichen Zusammenhang dargestellt.

In der oberen Zeile RF sind mögliche einzustrahlende RF-Pulse, z.B. ein RF-Anregungspuls RF1 und ggf. ein RF-Refokussierungspuls RF2, angegeben.

In der zweiten Zeile GS sind mögliche und beispielhafte in Schichtselektionsrichtung zu schaltende Gradienten gezeigt, die z.B. für eine Schichtkodierung gleichzeitig mit eingestrahlten RF-Pulsen geschaltet werden können.

In der dritten Zeile GR sind mögliche und beispielhafte in Ausleserichtung zu schaltende Gradienten gezeigt, insbesondere ein bipolarer Auslesegradientenzug GT, welcher einer Reihe von in ihrer Polarität alternierenden, jedoch ansonsten gleichförmigen, Auslesegradienten umfasst.

In der vierten Zeile GP sind mögliche und beispielhafte in Phasenkodierrichtung zu schaltende Gradienten gezeigt, insbesondere zur bei Echoplanar-Verfahren zur Kodierung verschiedener k-Raumzeilen zwischen der Aufnahme einzelner Echosignale zu schaltende "Phasenblips".

In der untersten Zeile ADC ist die Aktivität eines Empfangs von Echosignalen dargestellt.

Nach Einstrahlen eines RF-Anregungspulses RF1 zum Anregen von Spins in dem Untersuchungsobjekt U werden Echosignale durch den RF-Anregungspuls RF1 in dem Untersuchungsobjekt U angeregter Spins in einem Auslesezeitraum MW durch Schalten von in ihrer Polarität alternierenden Auslesegradienten, die einen bipolaren Auslesegradientenzug GT bilden, aufgenommen und als Messdaten MD erfasst (Block 101).

Dies kann auf bekannte Art und Weise erfolgen. Gegebenenfalls kann nach dem Einstrahlen des RF-Anregungspulses RF1 und vor der Aufnahme von Echosignalen ein RF-Refokussierungspuls RF2 eingestrahlt werden, sodass refokussierte Echosignale erzeugt werden, die als Messdaten erfasst werden.

Das Schalten von in ihrer Polarität alternierenden Auslesegradienten wird nach dem Erfassen der Messdaten MD in dem Auslesezeitraum MW fortgeführt, sodass der Auslesegradientenzug GT über den Auslesezeitraum MW hinaus um einen Referenzauslesezeitraum RW, welcher mindestens drei (den Auslesegradientenzug GT fortsetzende) in ihrer Polarität alternierende weitere Auslesegradienten umfasst, verlängert ist. Dabei werden weiter gleichförmige Auslesegradienten alternierender Polarität geschaltet, sodass ein mechanischer, am Ende des Auslesezeitraums MW bestehender eingeschwungener Zustand, auch Steady-State genannt, weiter erhalten bleibt. Dass der Auslesegradientenzug GT somit über den Auslesezeitraum MW hinaus verlängert wird kann zu einer Verlängerung der Wiederholzeit TR der Pulssequenz führen. Diese Verlängerung ist aber in aller Regel gering, in der Größenordnung einiger weniger Millisekunden, z.B. zwei bis vier Millisekunden. Es ist sogar möglich, dass es trotz der Verlängerung des Auslesegradientenzugs GT nicht zu einer Verlängerung der Wiederholzeit TR der Pulssequenz kommt, z.B. wenn andere Bedingungen, etwa bezüglich eines gewünschten Kontrasts, in der Zeiteinteilung der Pulssequenz genügend Zeit für die weiteren Auslesegradienten erlauben.

Durch Aufnehmen von mindestens drei weiteren Echosignalen während jeweils eines der mindestens drei weiteren Auslesegradienten in dem Referenzauslesezeitraum RW werden Referenzdaten RD erfasst (Block 103).

Auf Basis der erfassten Referenzdaten RD werden Korrekturdaten KD zur Phasenkorrektur von in den Messdaten MD enthaltenen Phasenfehlern bestimmt (Block 105).

Auf Basis der bestimmten Korrekturdaten KD können die erfassten Messdaten MD zu korrigierten Messdaten MD* korrigiert werden (Block 107). Auf Grundlage der korrigierten Messdaten MD* können Bilddaten BD rekonstruiert werden, die nicht oder nur gering mit Artefakten belastet sind und somit eine hohe Bildqualität aufweisen.

Wie in dem Beispiel der Figur 5 dargestellt kann vorgesehen sein während zumindest eines, insbesondere des unmittelbar auf den Auslesezeitraum MW folgenden, weiteren Auslesegradienten keine Referenzdaten RD zu erfassen. Dies ist insbesondere dann sinnvoll, wenn beispielsweise noch eine Präparation, z.B. der Kodierung, durchzuführen ist, bevor Echosignale aufgenommen und als Referenzdaten RD erfasst werden.

Beispielsweise kann während zumindest eines unmittelbar auf den Auslesezeitraum folgenden weiteren Auslesegradienten in Phasenkodierrichtung ein Rückführungsgradient Gr geschaltet werden, der für eine Rückführung der Kodierung auf eine in Phasenkodierrichtung für die Referenzdaten RD gewünschte, z.B. insbesondere für oben beschriebene Korrekturverfahren, bei welchen drei Navigatorsignale als Referenzdaten RD erfasst werden, zentrale, Position sorgt. Es ist zwar denkbar das Pulssequenzschema derart zu gestalten, dass während des Auslesezeitfensters MW eine Phasenkodierung derart erfolgt, dass die Phasenkodierung mit dem letzten in dem Auslesezeitfenster MW aufgenommenen Echosignal bereits wieder einen für die Referenzdaten RD gewünschten Wert hat. Durch ein Schalten eines Rückführungsgradienten Gr zu Beginn des Referenzauslesezeitraums RW kann ohne großen zeitlichen Aufwand jedoch auch eine gängige, nicht extra anzupassende Phasenkodierung während des Auslesezeitfensters MW verwendet werden.

Eine maximale Amplitude des Rückführungsgradienten Gr kann hierbei derart (klein) gewählt werden, dass durch den Rückführungsgradienten Gr erzeugte Wirbelströme unter einem vorgegebenen Schwellwert liegen. Dabei kann es vorkommen, dass ein Schalten des Rückführungsgradienten Gr mehr Zeit in Anspruch nimmt, als ein weiterer Auslesegradient in dem Referenzauslesezeitraum RW geschaltet ist. In diesem Fall kann sich der Rückführungsgradient Gr auch über zwei weitere Auslesegradienten des Referenzauslesefensters erstrecken, sodass erst während eines dritten weiteren Auslesegradienten ein erstes Echosignal als Referenzdaten RD erfasst wird. Der hierbei erhöhte Zeitbedarf ist gegen den Vorteil der verringerten Wirbelströme abzuwägen.

Der RF-Anregungspuls RF1 kann ein Multiband-RF-Anregungspuls sein, der N, mit N größer gleich 2, Schichten in dem Untersuchungsobjekt gleichzeitig anregt. Hierbei kann für die Anregung der Spins in dem Untersuchungsobjekt wie in den oben genannten Schriften US10162037B2, der US12025686B2 und der US20240036142A1 vorgegangen werden. Die Aufnahme der Echosignale als Referenzdaten RD erfolgt jedoch erfindungsgemäß nach dem Auslesezeitfenster MW, in welchem die Echosignale als Messdaten MD aufgenommen werden.

Insbesondere im Rahmen von SMS-Verfahren, bei welchen mehrere Schichten simultan angeregt werden, kann im Referenzauslesezeitraum RW zwischen weiteren Auslesegradienten eine Phasenkodierung, z.B. in Phasenkodierrichtung und/oder in Schichtselektionsrichtung, ungleich Null erzeugt werden, sodass phasenkodierte weitere Echosignale aufgenommen und als Referenzdaten erfasst werden. In Figur 5 sind schematisch im Referenzauslesezeitraum RW Gradientenblips für eine derartige Kodierung eingezeichnet. Hierbei kann beispielsweise wie in einer der bereits genannten Schriften US10162037B2, der US12025686B2 und der US20240036142A1 vorgegangen werden, um entsprechend den dort beschriebenen Verfahren zur Phasenkorrektur kodierte Referenzdaten RD zu erhalten.

Es kann bei einer derartigen Phasenkodierung der Referenzdaten, insbesondere bezüglich deren Stärke und Richtung, also so vorgegangen werden, dass eine Phasenkodierung aufgenommener weiterer Echosignale einer vorgesehenen Phasenkodierung von als Referenzdaten RD verwendeten Echosignalen eines bei der Bestimmung der Korrekturdaten KD verwendeten Korrekturverfahrens entspricht.

Eine Anzahl der als Referenzdaten RD erfassten im Referenzauslesezeitraum RW aufgenommenen weiteren Echosignale kann mindestens, insbesondere genau, einer Anzahl für ein bei der Bestimmung der Korrekturdaten KD verwendetes Korrekturverfahrens vorgesehener Echosignale entsprechen. Beispielsweise kann bereits eine Aufnahme von drei Echosignalen in den Referenzauslesezeitraum RW für bekannte Korrekturverfahren ausreichen. Andere Korrekturverfahren, wie z.B. die in den bereits genannten US10162037B2, der US12025686B2 und der US20240036142A1 beschriebenen, verlangen eine höhere Anzahl an aufgenommenen Echosignalen als Referenzdaten RD, beispielsweise sechs oder mehr.

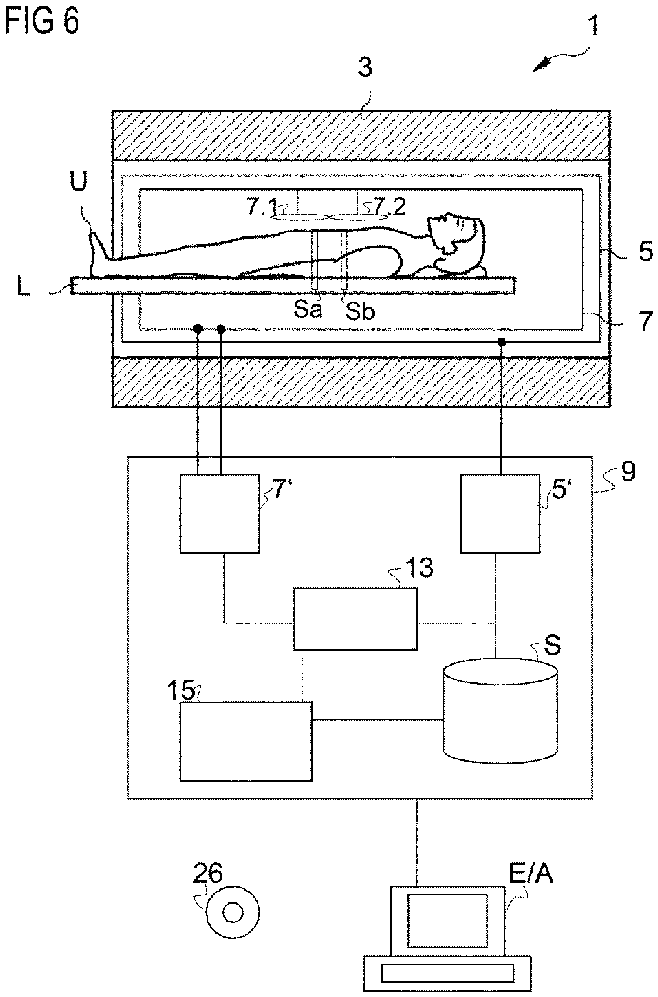

Figur 6 stellt schematisch eine erfindungsgemäße Magnetresonanzanlage 1 dar. Diese umfasst eine Magneteinheit 3 zur Erzeugung des Grundmagnetfeldes, eine Gradienteneinheit 5 zur Erzeugung der Gradientenfelder, eine Hochfrequenzeinheit 7 zur Einstrahlung und zum Empfang von Hochfrequenzsignalen und eine zur Durchführung eines erfindungsgemäßen Verfahrens ausgebildete Steuereinrichtung 9.

In der Figur 6 sind diese Teileinheiten der Magnetresonanzanlage 1 nur grob schematisch dargestellt. Die Hochfrequenzeinheit 7 kann aus mehreren Untereinheiten bestehen und beispielsweise mehrere Spulen umfassen. Insbesondere kann die Hochfrequenzeinheit 7 eine Körperspule umfassen, die fest in der Magnetresonanzanlage 1 integriert ist, die mehrere Antennenelemente umfassen kann. Weiterhin kann die Hochfrequenzeinheit 7 ein oder mehrere verschiedenen Lokalspulen 7.1, 7.2 umfassen, die entweder nur zum Senden von Hochfrequenzsignalen oder nur zum Empfangen der ausgelösten Hochfrequenzsignale oder für beides ausgestaltet sein können, und ihrerseits mehrere Antennenelemente und zugehörige Spulenkanäle umfassen können.

Zur Untersuchung eines Untersuchungsobjektes U, beispielsweise eines Patienten oder auch eines Phantoms, kann dieses auf einer Liege L in die Magnetresonanzanlage 1 in deren Messvolumen eingebracht werden. Die Schichten Sa oder Sb stellen exemplarische Zielvolumen des Untersuchungsobjekts dar, aus welchen Echosignale nacheinander oder auch simultan aufgenommen und als Messdaten erfasst werden können.

Die Steuereinrichtung 9 dient der Steuerung der Magnetresonanzanlage 1 und kann insbesondere die Gradienteneinheit 5 mittels einer Gradientensteuerung 5' und die Hochfrequenzeinheit 7 mittels einer Hochfrequenz-Sende-/Empfangs-Steuerung 7' steuern. Die Hochfrequenzeinheit 7 kann hierbei mehrere Kanäle umfassen, auf denen Signale gesendet oder empfangen werden können.

Die Hochfrequenzeinheit 7 ist zusammen mit ihrer Hochfrequenz-Sende-/Empfangs-Steuerung 7' für die Erzeugung und das Einstrahlen (Senden) eines Hochfrequenz-Wechselfeldes zur Manipulation der Spins in einem zu manipulierenden Bereich (beispielsweise in zu messenden Schichten Sa, Sb) des Untersuchungsobjekts U zuständig. Dabei wird die Mittenfrequenz des, auch als B1-Feld bezeichneten, Hochfrequenz-Wechselfeldes in aller Regel möglichst so eingestellt, dass sie nahe der Resonanzfrequenz der zu manipulierenden Spins liegt. Abweichungen von der Mittenfrequenz von der Resonanzfrequenz werden als Off-Resonanz bezeichnet. Zur Erzeugung des B1-Feldes werden in der Hochfrequenzeinheit 7 mittels der Hochfrequenz-Sende-/Empfangs-Steuerung 7' gesteuerte Ströme an den HF-Spulen angelegt.

Weiterhin umfasst die Steuereinrichtung 9 eine Referenzdateneinheit 15 zur Steuerung einer erfindungsgemäßen Aufnahme von Referenzdaten zur Phasenkorrektur. Die Steuereinrichtung 9 ist insgesamt dazu ausgebildet, ein erfindungsgemäßes Verfahren durchzuführen.

Eine von der Steuereinrichtung 9 umfasste Recheneinheit 13 ist dazu ausgebildet alle für die nötigen Messungen und Bestimmungen nötigen Rechenoperationen auszuführen. Hierzu benötigte oder hierbei ermittelte Zwischenergebnisse und Ergebnisse können in einer Speichereinheit S der Steuereinrichtung 9 gespeichert werden. Die dargestellten Einheiten sind hierbei nicht unbedingt als physikalisch getrennte Einheiten zu verstehen, sondern stellen lediglich eine Untergliederung in Sinneinheiten dar, die aber auch z.B. in weniger oder auch in nur einer einzigen physikalischen Einheit realisiert sein können.

Über eine Ein-/Ausgabeeinrichtung E/A der Magnetresonanzanlage 1 können, z.B. durch einen Nutzer, Steuerbefehle an die Magnetresonanzanlage geleitet werden und/oder Ergebnisse der Steuereinrichtung 9 wie z.B. Bilddaten angezeigt werden.

Ein hierin beschriebenes Verfahren kann auch in Form eines Computerprogramms vorliegen, welches Befehle umfasst, die das beschriebene Verfahren auf einer Steuereinrichtung 9 ausführen. Ebenso kann ein computerlesbares Speichermedium vorliegen, welches Befehle umfasst, die bei der Ausführung durch eine Steuereinrichtung 9 einer Magnetresonanzanlage 1 diese veranlassen, das beschriebene Verfahren auszuführen.

Unabhängig vom grammatikalischen Geschlecht eines bestimmten Begriffes sind Personen mit männlicher, weiblicher oder anderer Geschlechteridentität mit umfasst.

## Patentansprüche

1. Verfahren zur Aufnahme von Referenzdaten (RD) zur Korrektur von mittels einer Echoplanar-Sequenz mittels einer Magnetresonanzanlage (1) aus einem Untersuchungsobjekt (U) aufgenommenen Messdaten (MD) umfassend die Schritte:
- Einstrahlen eines RF-Anregungspulses (RF1) zum Anregen von Spins in dem Untersuchungsobjekt (U),
- Erfassen von Messdaten (MD) durch Aufnehmen von Echosignalen durch den RF-Anregungspuls (RF1) angeregter Spins in einem Auslesezeitraum (MW) durch Schalten von in ihrer Polarität alternierenden Auslesegradienten, die einen bipolaren Auslesegradientenzug (GT) bilden,
- Fortführen des Schaltens von in ihrer Polarität alternierenden Auslesegradienten nach dem Erfassen der Messdaten (MD) in dem Auslesezeitraum (MW), sodass der Auslesegradientenzug (GT) um einen Referenzauslesezeitraum (RW), welcher mindestens drei in ihrer Polarität alternierende weitere Auslesegradienten umfasst, verlängert ist,
- Erfassen von Referenzdaten (RD) durch Aufnehmen von mindestens drei weiteren Echosignalen während jeweils eines weiteren Auslesegradienten,
- Auf Basis der erfassten Referenzdaten (RD), Bestimmen von Korrekturdaten (KD) zur Phasenkorrektur von in den Messdaten (MD) enthaltenen Phasenfehlern.

2. Verfahren nach Anspruch 1, wobei während zumindest eines, insbesondere des unmittelbar auf den Auslesezeitraum (MW) folgenden, weiteren Auslesegradienten keine Referenzdaten (RD) erfasst werden.

3. Verfahren nach Anspruch 2, wobei während zumindest eines unmittelbar auf den Auslesezeitraum (MW) folgenden weiteren Auslesegradienten in Phasenkodierrichtung ein Rückführungsgradient (Gr) geschaltet wird, der für eine Rückführung der Kodierung auf eine in Phasenkodierrichtung für die Referenzdaten (RD) gewünschte, z.B. zentrale, Position sorgt.

4. Verfahren nach Anspruch 3, wobei eine maximale Amplitude des Rückführungsgradienten (Gr) derart (klein) gewählt ist, dass durch den Rückführungsgradienten (Gr) erzeugte Wirbelströme unter einem vorgegebenen Schwellwert liegen.

5. Verfahren nach einem der vorhergehenden Ansprüche, wobei der RF-Anregungspuls (RF1) ein Multiband-RF-Anregungspuls ist, der N, mit N größer gleich 2, Schichten in dem Untersuchungsobjekt (U) gleichzeitig anregt.

6. Verfahren nach Anspruch 5, wobei in dem Referenzauslesezeitraum (RW) zwischen weiteren Auslesegradienten eine Phasenkodierung ungleich Null erzeugt wird, sodass phasenkodierte weitere Echosignale aufgenommen und als Referenzdaten (RD) erfasst werden.

7. Verfahren nach Anspruch 6, wobei eine Phasenkodierung aufgenommener weiterer Echosignale einer vorgesehenen Phasenkodierung von als Referenzdaten (RD) verwendeten Echosignalen eines bei der Bestimmung der Korrekturdaten (KD) verwendeten Korrekturverfahrens entspricht.

8. Verfahren nach einem der vorhergehenden Ansprüche, wobei die Anzahl der als Referenzdaten (RD) erfassten aufgenommenen weiteren Echosignale mindestens, insbesondere genau, einer Anzahl für ein bei der Bestimmung der Korrekturdaten (KD) verwendetes Korrekturverfahrens vorgesehener Echosignale entspricht.

9. Magnetresonanzanlage (1) umfassend, eine Magneteinheit (3), eine Gradienteneinheit (5), eine Hochfrequenzeinheit (7) und eine Steuereinrichtung (9) mit einer Hochfrequenz-Sende-/Empfangs-Steuerung (7') und mit einer Referenzdateneinheit (15), wobei die Steuereinrichtung (9) dazu ausgebildet ist, ein Verfahren nach einem der Ansprüche 1 bis 8 auf der Magnetresonanzanlage (1) auszuführen.

10. Computerprogramm, umfassend Befehle, die bei der Ausführung des Programms durch eine Steuereinrichtung (9) einer Magnetresonanzanlage (1) diese veranlassen, das Verfahren nach einem der Ansprüche 1 bis 8 auszuführen.

11. Computerlesbares Speichermedium, umfassend Befehle, die bei der Ausführung durch eine Steuereinrichtung (9) einer Magnetresonanzanlage (1) diese veranlassen, das Verfahren nach einem der Ansprüche 1 bis 8 auszuführen.
